# EUROPEAN PATENT SPECIFICATION

(11) **EP 1 257 613 B1**
(45) Date of publication and mention of the grant of the patent: **15.09.2004**
(21) Application number: 01909359.0
(22) Date of filing: 14.02.2001
(51) Int. Cl.: C09K 19/54

(54) **OPTICAL CONNECTION OF WAVEGUIDES OF AN OPTICAL ELEMENT USING A NEAR INFRARED SENSITIVE PHOTOPOLYMERIZABLE COMPOSITION**
OPTISCHES VERBINDEN VON WELLENLEITERN EINES OPTISCHEN ELEMENTS UNTER BENUTZUNG EINER IM NAHEN INFRAROT EMPFINDLICHEN, PHOTOPOLYMERIZIERBAREN ZUSAMMENSETZUNG
LIAISON OPTIQUE DES GUIDES D'ONDES D'UN ELEMENT OPTIQUE UTILISANT UNE COMPOSITION PHOTOPOLYMERISABLE SENSIBLE AU PROCHE INFRAROUGE

(30) Priority: 14.02.2000 CA 2298345
(43) Date of publication of application: 20.11.2002
(73) Proprietor: UNIVERSITE LAVAL, Quebec, Quebec G1K 7P4 (CA)
(72) Inventor: GALSTIAN, Tigran, Ste-Foy, Québec G1V 2W1 (CA); BOIKO, Yuri, San Diego, CA 92121 (US)
(74) Representative: Casalonga, Axel
(86) International application number: PCT/CA2001/000162
(87) International publication number: WO 2001/059031

(56) References cited:
- PILOT P ET AL: "ANGULAR SELECTIVITY OF HOLOGRAPHIC POLYMER DISPERSED LIQUID CRYSTALMATERIALS WITH NEAR IR SENSITIVITY" PROCEEDINGS OF THE SPIE, SPIE, BELLINGHAM, VA, US, vol. 3638, 26 January 1999 (1999-01-26), pages 26-34, XP001015234
- NOIRET N ET AL: "PHOTOPOLYMERS FOR HOLOGRAPHIC RECORDING: V. SELF-PROCESSING SYSTEMSWITH NEAR INFRARED SENSITIVITY" PURE AND APPLIED OPTICS, BRISTOL, GB, vol. 3, no. 1, 1994, pages 55-71, XP000994604 ISSN: 0963-9659 cited in the application

## Description

The present invention relates to a photopolymerizable composition which is sensitive to near infrared radiation, and to the use of such a composition for optically connecting two waveguides of an optical element and for producing various optical devices. The composition of the invention is particularly useful for producing holographic polymer dispersed liquid crystal (H-PDLC) materials having improved switching characteristics.

Infrared diode sources are largely used in integrated photonic circuits and the list of their applications grows very rapidly. The management of the .radiation of these sources requires the fabrication of optical elements such as lenses, interconnects, modulators, etc. Holographic diffractive elements are emerging as very promising for these applications. These include wavelength selective holographic interconnects (1 to N, or M to N), couplers, lenses, mirrors. Today, a new class of holographic polymer dispersed liquid crystal materials (H-PDLCs) is considered to be one of the most viable technologies for the development of reflective color displays, switchable holographic optical elements (such as Bragg gratings for wavelength division multiplexing (WDM) devices), switchable-focus lenses, etc. See for example Crawford et al., "Reflective color LCDs based on H-PDLC and PSCT technologies", *J*. *Soc*. *Information Display*, 1996, 5(1); Domash et al., "Electronically switchable waveguide Bragg gratings for WDM routing", 1997 Digest of the IEEE/LEOS Summer Topical Meetings: Vertical-Cavity Lasers/Technologies for a Global Information Infrastructure/WDM Components Technology; and Domash et aL, "Switchable-focus lenses in holographic polymer dispersed liquid crystal", Proceedings of the SPIE - The International Society for Optical Engineering, vol. 2689, (Diffractive and Holographic Optics Technology III, San Jose, CA, USA, 1-2 Feb. 1996.) SPIE-Int. Soc. Opt. Eng, 1996. p.188-94.

Commercially available holographic materials are generally sensitive only in the UV/visible region of the optical spectrum. Thus, the actual fabrication of above-mentioned elements requires an initial recording step, where a UV-visible laser source is used, and then, a further adaptation or adjustment of the obtained element for utilization with near infrared wavelengths (e.g. 790-850 nm or 1300-1500 nm), which are used in local or long distance communication systems. Due to strong astigmatism and divergence of the diode lasers used, this work is difficult and has poor efficiency. It would therefore be highly desirable to provide *in situ* recording of holographic diffractive elements with lasers, which are already integrated in the given photonic circuit, thus providing self-alignment of the photonic circuits. Thus, there is a need to extend the sensitivity of these materials up to communication wavelengths. Namely, for *in situ* holographic recording of optical components with diode lasers operating in the 790 - 855 nm region, among which there are vertical cavity surface emitting lasers (VCSEL), it is important to have H-PDLC materials with suitable holographic characteristics, which include high sensitivity and diffraction efficiency of the recording, low scattering and noise level, and low switching voltage.

Up to now, the sensitivity of the existing H-PDLC materials has been extended up to 790 nm only (Natarajan et al., Report on Photonics West'98, San Jose, January 1998). Thus, recently, research groups have demonstrated a holographic polymerization process in a polymer-dispersed liquid crystal composite that results in efficient electrically switchable Bragg gratings (ESBG) with low scattering. The compound is sensitive to the illumination from visible up to 790 nm.

On the other hand, photopolymerizable materials have been suggested with sensitivity in the 790 - 850 nm region. See for example EP 0 223 587; EP 0 387 087; EP 0 389 067; US 4,343,891; Chatterjee et al., *J*. *Am*. *Chem*. *Soc*., 1990, 112, 6329; Schuster et 1, *Photochem*. *Photobiol*. *A: Chem*., 1992, 65, 191; Chatterjee et al., *J*. *Am*. *Chem*. *Soc*., 1988, 110, 2326; Cooper et al., *J*. *Am*. *Chem*. *Soc.,* 1963, 85, 1590; and Noiret et al., *Pure and Applied Optics*, 1994, 3(1), 55-71. Imaging applications with low resolution (such as printing plates) were also successfully explored. Some of the materials were the subject of the study for holographic gratings recording and only very low level of performance was achieved (7 % of diffraction efficiency at sensitivity of about 300 - 500 mJ/cm²), as reported in the mentioned Noiret et al. article *supra*. This low level of performance makes such polymers impractical for commercial application. However, H-PDLC materials sensitive to the spectral region of 790 - 855 nm have remained unexplored.

The object of the present invention is to provide a method of optically connecting at least two waveguides of an optical element, comprising the steps of:
a) providing an optical element having at least two waveguides to be optically connected;
b) providing a photopolymerizable composition
   - a photopolymerizable monomer or oligomer, or a mixture thereof capable of forming a polymer having predetermined optical properties;
   - a photoinitiator sensitive to near infrared radiation;
c) applying the photopolymerizable composition between the waveguides to be connected; and
d) exposing the waveguides with the photopolymerizable composition therebetween to near infrared radiation to cause polymerization of the monomer or oligomer, or mixture thereof, thereby forming an optical connection between the waveguides.

Preferably, the near infrared radiation is transmitted during step (d) through at least one of the waveguides.

The photopolymerizable composition of the present invention is sensitive to light in the near infrared region of the optical spectrum.

Use is preferably made of an acrylate monomer. A mixture comprising an acrylate monomer and an acrylate oligomer can also be used.

According to a preferred embodiment, the photoinitiator comprises a sensitizer and an initiator, wherein the sensitizer is efficiently excited by the near infrared radiation to produce an excited sensitizer, and the initiator is efficiently excited by the excited sensitizer to cause initiation of polymerization of the monomer or oligomer, or mixture thereof. The sensitizer preferably comprises a dye absorbing near infrared radiation, such as a cyano-compound, for example cyanine. The initiator is preferably an electron donor comprising a heavy atom such as bromine, iodine, boron, iron and the like, for example, CBr₄, CHBr₃, CHI₃, etc.

The composition may further comprise a filler having optical properties selected to contrast with the optical properties of the polymer. The filler preferably comprises a liquid crystal.

The above composition can be applied to prototyping and allows the implementation of optical coupling of waveguides as well as the manufacture of optical devices, in particular diffractive and holographic optical devices. Advantageously, such devices can be made using light in the infrared region coming from a light source that is already used in the optical device, such as commonly used communications light sources.

According to another aspect of the invention, there is provided a process for producing an optical device; comprising the steps of:
a) providing an optical element;
b) providing a photopolymerizable composition as defined above;
c) applying a layer of the photopolymerizable composition onto the optical element; and
d) exposing the optical element with the layer of photopolymerizable composition thereon to near infrared radiation to cause polymerization of the monomer or oligomer, or mixture thereof, and formation of a recording pattern on the optical element, the recording pattern comprising areas having different densities of filler in exposed and unexposed areas of the layer, thereby obtaining an optical device having thereon areas with different optical properties.

In a preferred embodiment, step (d) is followed by a second exposure to the near infrared radiation to cause polymerization of any remaining unpolymerized monomer oligomer.

Preferably, step (d) is carried out to ensure that substantially all of the monomer or oligomer has polymerized. The recording pattern may represent a diffraction pattern or a diffractive lens. When the recording pattern is a diffraction pattern, the diffractive element of the optical device is preferably switchable between two optical states when placed in a controllable electric field.

Further features and advantages of the invention will become more readily apparent from the following description of a preferred embodiment, with reference to the accompanying drawings in which:

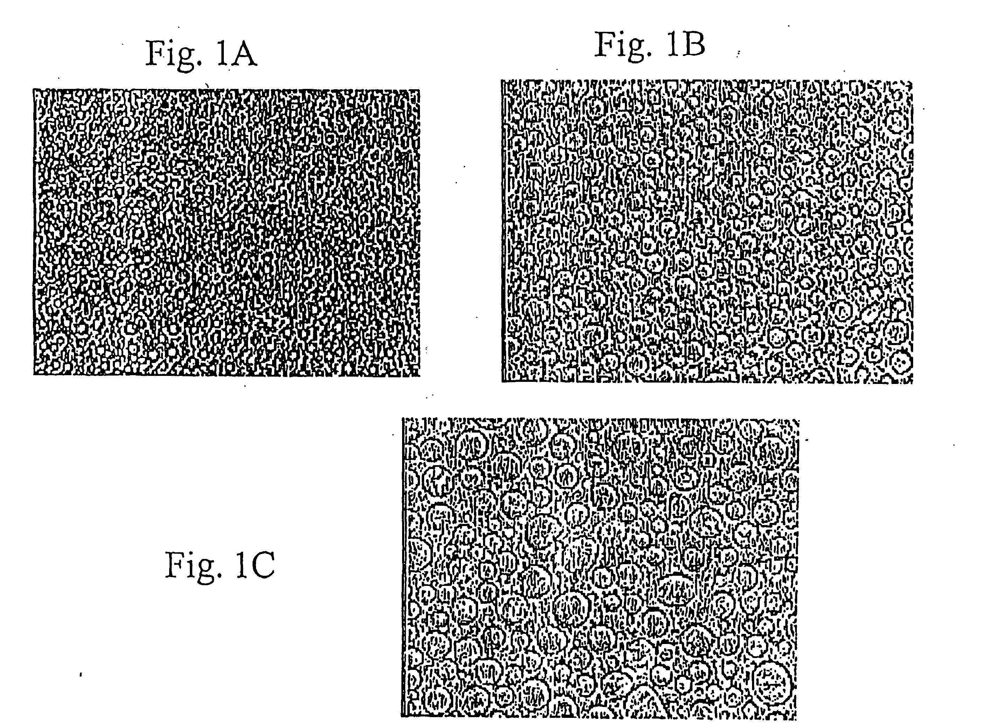

Figures 1A, 1B and 1C illustrate three increasing density levels of liquid crystal droplets in a H-PDLC material produced according to a preferred embodiment of the invention;
Figure 2 illustrates an exposure set-up for *in situ* recording and monitoring of a diffractive pattern on the H-PDLC material;
Figure 3 illustrates a graph of diffracted signal strength as a function of exposure time for the H-PDLC material, showing monotonous recording kinetics; and
Figure 4 illustrates a graph of diffracted signal strength as a function of extended readout exposure time for the H-PDLC material, showing very high temporal and readout stability.

The present invention offers a new technical solution needed to provide efficient *in situ* recording of highly efficient and switchable holographic elements in the near infrared region (790 - 850 nm) of the optical spectrum. The preferred embodiment is the use of a photopolymerizable composition which comprises a mixture of photopolymerizable acrylate monomer and oligomer, a photoinitiating system including a dye sensitizer excitable by near infrared radiation, an initiator, preferably an electron donor, an optional co-initiator, and a liquid crystal compound as a filler.

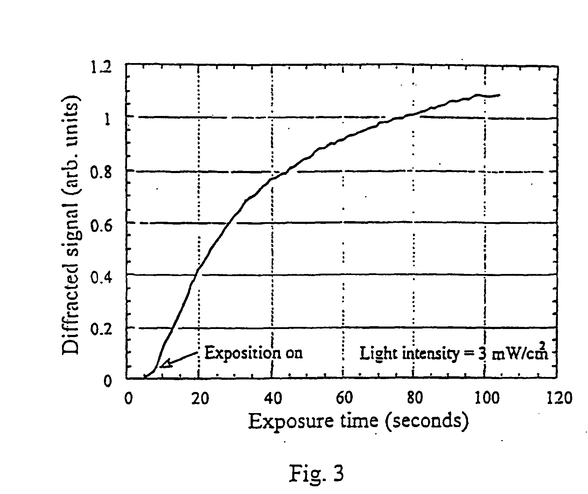

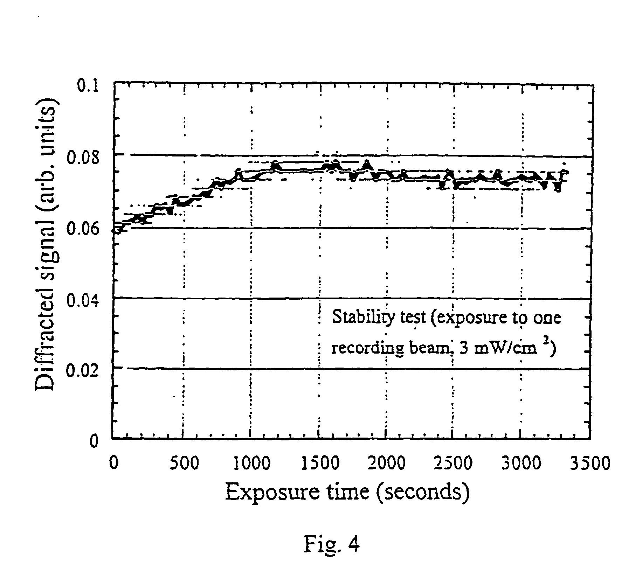

The resulting recorded holograms have high diffraction efficiency and unexpected wavelength dependence (50% at 850 nm, and 75% at 1550 nm). Indeed, with a proper choice of the components of the composition, the dispersion of the diffraction efficiency can be managed, that is, making this dependence to be growing or decreasing with the wavelength. In addition, the composition allows the DC field control of the diffraction efficiency, which can provide, e.g., switchable wavelength division multiplexing (WDM) elements. The present material shows monotonous recording kinetics (Fig. 3) and very high temporal and readout stability (after fixing; Fig. 4). The fixing is performed by uniform light illumination and no curing is required, thus increasing the capacity of the *in situ* fabrication of various integrated optical circuits.

The composition of the present invention has great potential since it can be modified depending on the desired performance of the final product. However, the main components remain the same. Preferred ranges of concentrations for each component are:
- photopolymerizable acrylate monomer and oligomer 40 - 80 weight %
- dye sensitizer 0.02 - 1.0 weight %
- initiator 10 - 15 weight %
- co-initiator 0 - 10 weight %
- liquid crystal 10 - 50 weight %
- surfactant 0 - 5 weight%

### Preparation of Composition

The preparation is preferably carried out in two stages to ensure proper solubility conditions and prevent undesirable thermal reactions.

In a first stage, the following three solutions are prepared separately by magnetic stirring at 70-90°C and complemented with ultrasonic processing:
Solution #1: dye sensitizer with liquid acrylate monomer/oligomer;
Solution #2: initiator with liquid acrylate monomer/oligomer; and
Solution #3: co-initiator with liquid acrylate monomer/oligomer.

Mixing is continued until solubilization is complete and the solutions become homogeneous. The magnetic stirring and ultrasonic processing follow each other and each is conducted for about 30 minutes. The solutions thus obtained are cooled down to and stored at room temperature for the second stage.

As a specific example, the following solutions were prepared:
Solution #1: (IR140™ : DPEPA) = (0.02 to 0.2) : 33;
Solution #2: (CBr₄ : DPEPA) = 0.6 : 3.3; and
Solution #3: (EDMABzt : DPEPA) = 0.4 : 33;
wherein
IR140™ is a cyanine dye (Aldrich); DPEPA is di-penta-erithrithol-penta-acrylate (Sartomer Company), and EDMABzt is ethyl-dimethyl-amino-benzoate (Aldrich).

In the second stage, the solutions are mixed together at room temperature with all desired additives and fillers, including the liquid crystaI compound, additional monomer/oligomer and other optional conventional additives such as surfactants or plasticizers. The resulting solution is then filtered through a microporous filter to remove dust and other solid particles, and centrifuged to remove bubbles, thereby obtaining the desired photopolymerizable composition.

' Examples of components which may be used in the preparation of the desired composition include:
- as acrylate monomer/oligomer: DPEPA, 2-ethoxy-ethoxy-ethyl acrylate ester, urethane acrylate CN975™ and the like;
- as cyanine dye: IR-140™, IR-132™, IR-143™, IR-786™ (Aldrich);
- as initiator, i.e. heavy atom (preferably Br-, B-, I- or Fe-) containing compound: CBr₄, CHBr₃, CHI₃ ;
- as co-initiator: EDMABzt; and
- as liquid crystal compound: E7™, MBBA™ (Merck). MBBA™ is also known as N-(p-methoxybenzylidene)-p-butylaniline.

### Sample Preparation

A layer of the above-prepared composition is disposed between two slides. A conducting coating, for example, a transparent indium tin oxide coating, can be created on the slides for switching operation. The thickness of the layer is defined by spacers, for example, made of Mylar™ film.

### Exposure of Sample

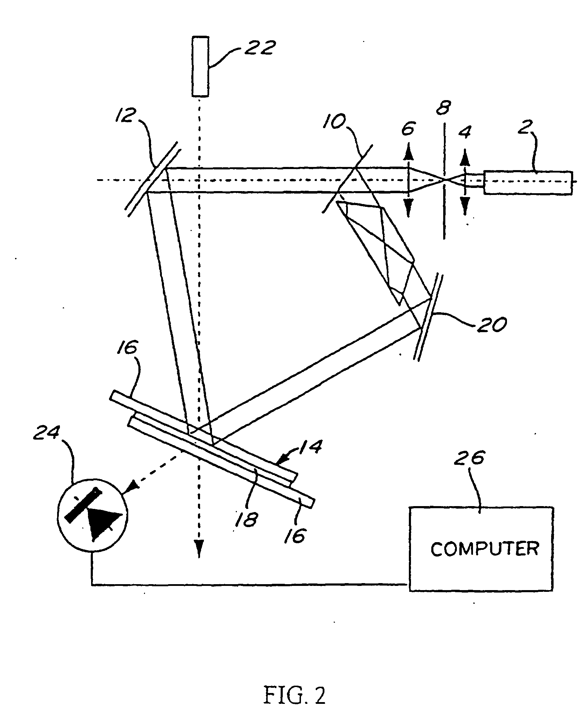

Exposure of the sample is carried out in the set up represented in Figure 2. An 790 - 855 nm emitting diode laser 2 is used as an *in situ* recording source. The laser light is focused into a beam by lenses 4 and 6 and pinhole 8, which is directed to beamsplitter 10. The first split beam is directed to mirror 12 and then onto the cell 14 comprising the aforementioned two slides 16 with a layer 18 of photopolymerizable composition therebetween, while the second split beam is directed to mirror 20 and then onto cell 14. The readout wavelength from laser 22 is chosen to be 633 nm, which is out of the sensitivity region of the sensitizer used to ensure nondestructive monitoring of the recording process. Monitoring is carried out using a photodetector 24 and a computer 26. After recording, the sample is subjected to a stability test, which consists of a uniform exposure to one of the
recording beams. This uniform exposure to the recording beam leads to full polymerization in all areas, whether exposed and non-exposed. If the hologram is stable, such an exposure would fix the created modulation of the refractive index, referred to herein as "hologram fixing". Alternatively, i.e. if the hologram is unstable, such an exposure would lead to partial or complete erasure of the hologram.

The following non-limiting examples further illustrate the invention.

### Example 1

According to the procedure described above, the following photopolymerizable composition was prepared: (IR140™/DPEPA) : (CBr₄/DPEPA) : (EDMABzt/DPEPA) : E7 : 2 EEEA = 130 : 130 : 130 : 130 : 2;
wherein,
(IR140™/DPEPA) = (0.02 to 0.2) : 3.3;
(CBr₄/DPEPA) = 0.6 : 3.3;
(EDMABzt/DPEPA) = 0.4 : 3.3.

For a thickness of 45 micrometers and spatial frequency of about 1200 lines/mm, the samples obtained exhibit the following recording parameters:
- diffraction efficiency (p-polarization and wavelengths from 633 through 1500 nm): η_{P}, λ_{=633-1500 nm} = almost steady value in the range between 50 and 65 %;
- diffraction efficiency (s-polarization, at 633 nm): ηₚ, λ_{=633 nm} = 21 ± 3%.

### Example 2

According to the procedure described above, the following photopolymerizable composition was prepared:
(IR140™/DPEPA) : (CBr₄/DPEPA) : (EDMABzt/DPEPA) : E7 = 1 : 1 : 1 : 1, wherein
(IR140™/DPEPA) = (0.02 to 0.2) : 3.3;
(CBr₄/DPEPA) = 0.6 : 3.3;
(EDMABzt/DPEPA) = 0.4 : 3.3;
and which, at a thickness of 45 micrometers and a spatial frequency of 1200 lines/mm, exhibits the following recording parameters:
- diffraction efficiency ηₚ, λ_{=663 nm} = 47 ± 4%;
- diffraction efficiency ηₚ, λ_{=1500 nm} = 70 ± 5%;
- diffraction efficiency ηₛ, λ_{=633 nm} = 50 ± 4%;
- diffraction efficiency ηₛ, λ_{=1500 nm} = 8 ± 2%.

### Example 3

According to the procedure described above, the following photopolymerizable composition was prepared:
(IR140™/DPEPA) : (CBr₄/DPEPA) : (EDMABzt/DPEPA) : MBBA = 1 : 1 : 1:1,
   wherein
(IR140™/DPEPA) = (0.02 to 0.2) : 3.3;
(CBr₄/DPEPA) = 0.6 3.3;
(EDMABzt/DPEPA) = 0.4 : 3.3;
and which, at a thickness of 45 micrometers and a spatial frequency of 1200 lines/mm, exhibits the following recording parameters:
- diffraction efficiency ηₚ, λ_{=633 nm} = 47 ± 4%;
- diffraction efficiency ηₛ, λ_{=633 nm} = 50 ± 4%.

### Example 4

According to the procedure described above, the following photopolymerizable composition was prepared:
(IR140™/DPEPA) : (CBr₄/DPEPA) : (EDMABzt/DPEPA) : (E7:MBBA) = 1 : 1 : 1 : 1,
   wherein
(IR140™/DPEPA) = (0.02 to 0.2) 3.3;
(CBr₄/DPEPA) = 0.6 : 3.3;
(EDMABzt/DPEPA) = 0.4 : 3.3;
(E7 : MBBA) = 1 : 1;
and which, at a thickness of 45 micrometers and a spatial frequency of 1200 lines/mm, exhibits the following recording parameters:
- diffraction efficiency ηₚ, λ_{=633 nm} = 49 ± 4%;
- diffraction efficiency ηₛ, λ_{=633 nm} = 52 ± 4%.

As previously mentioned, the composition may potentially be improved by adding surfactants, modifying the monomer/oligomer system and modifying the filler, namely the liquid crystal (LC). For instance, a change of LC gives significant change of properties when E7 is substituted by MBBA. In particular, the E7 base compound is anisotropic, while the MBBA gives isotropic films with high diffraction efficiency of the recording.

Mixture with MBBA + E7 gives very intricate texture. Other possible modifications of LC involve ferroelectric LCs, discotic LCs, fluorinated LCs and some others.

Monomer modification is also contemplated, as for example 2EEEA, which gives "zero dispersion of diffraction efficiency" of the recording. Another monomer (urethaneacrylate CN975™) gives positive dispersion of diffraction efficiency. Negative dispersion was observed with DPEPA only.

The photopolymerizable composition according to the invention can be used as an optical coupling binder which is photoreacted using light from conventional diodes operating in the near infrared region. The light for photoreacting can be provided by an external light source, or in some cases from the waveguides being coupled.

The photopolymerizable composition can also be used in non-optical devices applications, such as laser controlled prototyping, in which near infrared laser light can be used to control photopolymerization in a computer controlled manufacturing device.

## Claims

1. A method of optically connecting at least two waveguides of an optical element, comprising the steps of:
a) providing an optical element having at least two waveguides to be optically connected;
b) providing a photopolymerizable composition comprising:
- a photopolymerizable monomer or oligomer, or a mixture thereof, capable of forming a polymer, and
- a photoinitiator sensitive to near infrared radiation;
c) applying the photopolymerizable composition between the waveguides to be connected; and
d) exposing the waveguides with the photopolymerizable composition therebetween to near infrared radiation to cause polymerization of the monomer or oligomer, or mixture thereof, thereby forming an optical connection between the waveguides.

2. A method according to claim 1, wherein the monomer is an acrylate monomer.

3. A method according to claim 1, wherein the oligomer is an acrylate oligomer.

4. A method according to claim 1, wherein the photoinitiator comprises a sensitizer and an initiator, wherein the sensitizer is efficiently excited by the near infrared radiation to produce an excited sensitizer, and the initiator is efficiently excited by the excited sensitizer to cause initiation of polymerization of the monomer or oligomer, or mixture thereof.

5. A method according to claim 4, wherein the sensitizer is a dye sensitizer.

6. A method according to claim 5, wherein the dye sensitizer is a cyano-compound.

7. A method according to claim 4, wherein the initiator is an electron donor.

8. A method according to claim 7, wherein the electron donor is a heavy atom containing compound.

9. A method according to claim 8, wherein the heavy atom containing compound is selected from the group consisting of carbon tetrabromide, carbon tribromide and carbon triiodide.

10. A method according to claim 9, wherein the heavy atom containing compound is carbon tetrabromide.

11. A method according to claim 4, wherein the photoinitiator further includes a co-initiator.

12. A method according to claim 11, wherein the co-initiator is ethyl-dimethyl-aminobenzoate.

13. A method according to claim 11, wherein the initiator is carbon tetrabromide and the co-initiator is ethyl-dimethyl-amino-benzoate.

14. A method according to claim 1, wherein in step (d) the near infrared radiation is transmitted through at least one of said waveguides.

## Patentansprüche

1. Verfahren zum optischen Verbinden wenigstens zweier Wellenleiter eines optischen Elements, welches die Schritte umfaßt:
a) Bereitstellung eines optischen Elements, das wenigstens zwei optisch zu verbindende Wellenleiter aufweist;
b) Bereitstellung einer photopolymerisierbaren Zusammensetzung bestehend aus:
- einem photopolymerisierbaren Monomer oder oligomer oder einer Mischung davon, welche ein Polymer bilden können und
- einem Photoinitiator, der empfindlich gegenüber nah-infraroter Strahlung ist;
c) Aufbringen der photopolymerisierbaren Zusammensetzung zwischen die zu verbindenden Wellenleiter und
d) Aussetzen der Wellenleiter mit der dazwischen befindlichen photopolymerisierbaren Zusammensetzung gegenüber infraroter Strahlung, um die Polymerisation des Monomers oder oligomers oder einer Mischung davon hervorzurufen, wodurch eine optische Verbindung der Wellenleiter hergestellt wird.

2. Verfahren nach Anspruch 1, wobei das Monomer ein Acrylatmonomer ist.

3. Verfahren nach Anspruch 1, wobei das oligomer ein Acrylatoligomer ist.

4. Verfahren nach Anspruch 1, wobei der Photoinitiator einen Sensibilisator und einen Initiator umfaßt, wobei der Sensibilisator durch die nah-infrarote Strahlung wirksam angeregt wird, um einen angeregten Sensibilisator zu bilden, und der Initiator wirksam durch den angeregten Sensibilisator angeregt wird, um die Initiierung der Polymerisation des Monomers oder Oligomers oder Mischungen davon hervorzurufen.

5. Verfahren nach Anspruch 4, wobei der Sensibilisator ein Farbstoffsensibilisator ist.

6. Verfahren nach Anspruch 5, wobei der Farbstoffsensibilisator eine Cyanoverbindung ist.

7. Verfahren nach Anspruch 4, wobei der Initiator ein Elektronendonor ist.

8. Verfahren nach Anspruch 7, wobei der Elektronendonor eine Verbindung ist, die Schweratome enthält.

9. Verfahren nach Anspruch 8, wobei die Verbindung, die Schweratome enthält, ausgewählt ist aus der Gruppe bestehend aus Tetrabromkohlenstoff, Tribromkohlenstoff und Triiodkohlenstoff.

10. Verfahren nach Anspruch 9, wobei die Verbindung, die Schweratome enthält, Tetrabromkohlenstoff ist.

11. Verfahren nach Anspruch 4, wobei der Photoinitiator desweiteren einen coinitiator einschließt.

12. Verfahren nach Anspruch 11, wobei der Coinitiator Ethyldimethylaminobenzoat ist.

13. Verfahren nach Anspruch 11, wobei der Initiator Tetrabromkohlenstoff und der Coinitiator Ethyldimethylaminobenzoat ist.

14. Verfahren nach Anspruch 1, wobei in Schritt (d) die nah-infrarote Strahlung durch wenigstens einen der Wellenleiter übertragen wird.

## Revendications

1. Procédé permettant de connecter optiquement au moins deux guides d'onde d'un élément optique, et comportant les étapes suivantes :
a) prendre un élément optique comportant au moins deux guides d'onde à connecter optiquement ;
b) prendre une composition photopolymérisable qui comprend :
- un monomère ou oligomère photopolymérisable, ou un mélange de tels composés, capable de former un polymère,
- et un photoamorceur sensible au rayonnement infrarouge proche ;
c) appliquer cette composition photopolymérisable entre les guides d'onde à connecter ;
d) et exposer à un rayonnement infrarouge proche ces guides d'onde et la composition photopolymérisable appliquée entre eux, pour provoquer la polymérisation du monomère, de l'oligomère ou de leur mélange, ce qui permet d'établir une connexion optique entre les guides d'onde.

2. Procédé conforme à la revendication 1, dans lequel le monomère est un monomère de type acrylate.

3. Procédé conforme à la revendication 1, dans lequel l'oligomère est un oligomère de type acrylate.

4. Procédé conforme à la revendication 1, dans lequel le photoamorceur comprend un sensibilisateur et un amorceur, et dans lequel le sensibilisateur est excité par le rayonnement infrarouge proche, ce qui a pour effet de donner un sensibilisateur excité, lequel sensibilisateur excité excite à son tour l'amorceur, ce qui a pour effet de provoquer l'amorçage de la polymérisation du monomère, de l'oligomère ou de leur mélange.

5. Procédé conforme à la revendication 4, dans lequel le sensibilisateur est un sensibilisateur colorant.

6. Procédé conforme à la revendication 5, dans lequel le sensibilisateur colorant est un composé à groupe cyano.

7. Procédé conforme à la revendication 4, dans lequel l'amorceur est un composé donneur d'électrons.

8. Procédé conforme à la revendication 7, dans lequel le composé donneur d'électrons est un composé à atome lourd.

9. Procédé conforme à la revendication 8, dans lequel le composé à atome lourd est choisi parmi du tétrabromure de carbone, du tribromure de carbone et du triiodure de carbone.

10. Procédé conforme à la revendication 9, dans lequel le composé à atome lourd est du tétrabromure de carbone.

11. Procédé conforme à la revendication 4, dans lequel le photoamorceur comprend en outre un co-amorceur.

12. Procédé conforme à la revendication 11, dans lequel le co-amorceur est du diméthylamino-benzoate d'éthyle.

13. Procédé conforme à la revendication 11, dans lequel l'amorceur est du tétrabromure de carbone et le co-amorceur est du diméthylamino-benzoate d'éthyle.

14. Procédé conforme à la revendication 1, dans lequel, dans l'étape (d), le rayonnement infrarouge proche est transmis par au moins l'un desdits guides d'onde.
